# EUROPÄISCHE PATENTSCHRIFT

(11) **EP 1 060 284 B1**
(45) Veröffentlichungstag und Bekanntmachung des Hinweises auf die Patenterteilung: **25.06.2003**
(21) Anmeldenummer: 99963246.6
(22) Anmeldetag: 16.11.1999
(51) Int. Cl.: C23C 14/16, C23C 30/00

(54) **SCHUTZSCHICHT**
PROTECTING LAYER
COUCHE PROTECTRICE

(30) Priorität: 19.12.1998 DE 19858913
(43) Veröffentlichungstag der Anmeldung: 20.12.2000
(73) Patentinhaber: MTU Aero Engines GmbH, 80995 München (DE)
(72) Erfinder: EICHMANN, Wolfgang, D-82178 Puchheim (DE)
(74) Vertreter: Einsele, Rolf W.
(86) Internationale Anmeldenummer: DE9903636
(87) Internationale Veröffentlichungsnummer: WO00037709

(56) Entgegenhaltungen:
- US-A- 5 312 696
- BELOUS M V ET AL: "Some properties of films obtained by vacuum condensation of aluminium, nickel, cobalt, copper, and the alloy Cu-Cr-Al" SOVIET PHYSICS JOURNAL, USA 1. NOV 1973 SEITEN 1060-1063, ÜBERSETZUNG AUS: IZVESTIYA VYSSHIKH UCHEBNYKH ZAVEDENII, FIZIKA, 1971, USSR, Nr. 8, 1971, Seiten 52-56, XP000904888 ISSN: 0021-3411
- SIDORENKO S I ET AL: "Electrophysical properties and phase compositions of Cu-Cr-Al alloy" RUSSIAN METALLURGY, UK, NR. 3, SEITEN 167-169, 1983, ÜBERSETZUNG AUS: IZVESTIYA AKADEMII NAUK SSSR, METALLY, 1983, USSR, Nr. 3, 1983, Seiten 189-192, XP000904890 ISSN: 0568-5303

## Beschreibung

Die Erfindung betrifft ein Bauteil aus einer Legierung auf Titan-, Nickel-, Kobalt- oder Eisenbasis mit mindestens einer lastübertragenden Kontaktfläche, gemäß dem Oberbegriff des Patentanspruches 1.

Die Oberflächen formschlüssiger Bauteilpaarungen in Gasturbinentriebwerken, insbesondere im Bereich Laufschaufelfuß/Scheibennut, neigen unter Schwingbeanspruchung mit hohen Frequenzen und kleinen Amplituden bei erhöhten Temperaturen zu sogenanntem Fretting Wear, d.h. zu Reibkorrosion bzw. Reibverschleiß. Temperaturen über ca. 450 °C beschleunigen den Verschleiß stark, wobei in ungünstigen Fällen durch sogenanntes Fretting Fatigue, d.h. durch Reibermüdung, verursachte Risse zu einem vorzeitigen Versagen der Bauteile führen können.

Aus der US-PS 5 312 696 ist eine Schutzschicht gegen Fretting Wear für Bauteile aus Nickel-, Kobalt- oder Titanlegierungen bekannt, welche aus Kupfer und Aluminium, gegebenenfalls mit Silizium als weiterem Legierungselement, besteht. Die Gewichtsanteile dieser Legierungselemente liegen zwischen folgenden Grenzwerten:

| | |
|---|---|
| Cu | 88 ö 96 % |
| Al | 4 ö 8 % |
| Si | 0 ö 4% |

Bevorzugte Zusammensetzungen dieser Aluminiumbronze ohne Siliziumzusatz sollen 92 % Cu und 8 % Al oder 92,5 % Cu und 7,5 % Al enthalten. Es hat sich gezeigt, dass Schichten gemäß diesem US-Patent zwar einen ausreichenden "Hochtemperaturoxidationswiderstand" besitzen, dass aber deren Warmfestigkeit bei Temperaturen über 450 °C drastisch abfällt, so dass bei den im Bereich Schaufelfuß/Scheibennut vorliegenden Flächenpressungen solche Schichten aus der Kontaktzone ausgewalkt werden und somit versagen ("Kuchenteigeffekt").

Die DE-PS 4229 600 betrifft einen Schichtaufbau für Titanbauteile mit einer metallischen Zwischenschicht und einer äußeren Schutzschicht, wobei letztere u.a. von einer Kupfer-Aluminiumlegierung, vorzugsweise in der Zusammensetzung CuAl8, gebildet wird. Abgesehen von der zusätzlich erforderlichen Zwischenschicht gilt für die Deckschicht aus Aluminiumbronze das selbe, was bereits oben zu der US-PS ausgeführt wurde. Die alternativ angegebenen Schutz-/Deckschichten stellen keine "Bronzen", d.h. keine Kupferlegierungen dar und werden daher in diesem Zusammenhang nicht näher betrachtet.

Aus der Druckschrift BELOUS M.V. ET AL.: "Some properties of vacuum-deposited films of aluminum, nickel, cobalt, copper, and Cu-Cr-Al alloy", SOVIET PHYSICS JOURNAL, USA, 1. NOV 1973, SEITEN 1060-1063, XP-000904888, ISSN: 0021-341, ist die Herstellung von dünnen Filmen einer Cu-Cr-Al-Legierung auf Substraten durch Vakuumverdampfung (PVD-Verfahren) bekannt, wobei diese Legierung z.B. 2,45 Gew.-% Cr, 4,89 Gew.-% Al und Rest Cu enthält. Solche Filme sind für elektrische und elektronische Bauelemente vorgesehen und sollen primär eine hohe elektrische Leitfähigkeit bei guter Haftung und thermischer Stabilität aufweisen. Die Substrate bestehen aus nichtleitenden Materialien, wie Keramik oder Kunststoff.

Aus der Veröffentlichung SIDORENKO S.I. ET AL.: "Electrophysical properties and phase compositions of Cu-Cr-Al alloy", RUSSIAN METALLURGY, UK, SEITEN 167 - 169, 1983, XP-000904890, ISSN: 0568-5303, ist die Herstellung einer vakuumverdampften, dünnen Schicht einer Cu-Cr-Al-Legierung mit 5 Gew-% Cr, 5 Gew-% Al sowie 90 Gew-% Cu auf einem pyrokeramischen Sitall-Substrat bekannt. Auch diese Schicht ist für elektrische bzw. elektronische Anwendungen vorgesehen.

Angesichts dieser bekannten Bauteile mit Schutzschichten und ihrer Nachteile besteht die Aufgabe der Erfindung darin, ein Bauteil mit einer Schutzschicht auf Basis einer Kupfer-Aluminium-Legierung für lastübertragende Kontaktflächen an dem Bauteil vorzuschlagen, welches auch bei Temperaturen über 450 °C noch eine hohe Widerstandsfähigkeit gegenüber Oxidation, Korrosion und Reibverschleiß aufweist und sich daher speziell für Anwendungen in Gasturbinentriebwerken eignet.

Diese Aufgabe wird durch die in Anspruch 1 gekennzeichneten Merkmale gelöst, in Verbindung mit den gattungsbildenden Merkmalen in dessen Oberbegriff. Die Schutzschicht des Bauteils wird von einer Legierung gebildet, welche als Hauptelement Kupfer, als weitere Elemente Aluminium und Chrom enthält. Als weiteres Element kann Eisen die Eigenschaften noch verbessern. Das Element Chrom (Cr), mit 2 ö 5 % Gewichtsanteil, bewirkt insbesondere eine Erhöhung der Warmfestigkeit und des Hochtemperaturoxidationswiderstandes bei gleichzeitig ausreichend duktilem Verhalten der Schutzschicht.

In den Unteransprüchen sind bevorzugte Ausgestaltungen des Bauteils nach dem Hauptanspruch gekennzeichnet.
So beträgt der Gewichtsanteil von Chrom in der Schutzschicht bevorzugt 3 %.
Für die Schichtdicke ist ein Maßbereich von 20 ö 50 µm vorteilhaft.
Es ist günstig, die Schicht im sogenannten PVD-Verfahren (Physical Vapour Deposition) abzuscheiden, wobei wiederum die Methode der Kathodenzerstäubung bevorzugt wird. Bei letzterer wird eine Kathode aus der Schutzschichtlegierung durch den Sputtereffekt in einer Glimmentladung abgetragen und der entstehende "Metalldampf" auf dem Bauteil, z.B. einer Verdichter-Laufschaufel, abgeschieden.

Das erfindungsgemäße Bauteil mit Schutzschicht hat sich bereits in Versuchen sehr gut bewährt.

## Patentansprüche

1. Bauteil aus einer Legierung auf Titan-, Nickel-, Kobalt- oder Eisenbasis mit mindestens einer lastübertragenden Kontaktfläche, welche in Größe und Richtung wechselnde, mechanische Lasten bei höheren Temperaturen überträgt, und mit einer Schutzschicht auf der Kontaktfläche gegen Reibverschleiß, Reibkorrosion und/oder Reibermüdung, insbesondere formschlüssig gehaltene Laufschaufel aus Titanlegierung mit einer Schutzschicht im Fußbereich für Gasturbinentriebwerke, **dadurch gekennzeichnet, dass** die Schutzschicht von einer Legierung aus folgenden Elementen mit folgenden Anteilen jeweils in Gewichtsprozent gebildet wird:
| | | |
|---|---|---|
| Aluminium | (Al) | 4 ö 8 % |
| Chrom | (Cr) | 2 ö 5 % |
| Eisen | (Fe) | 0 ö 3,5 % |
| Kupfer | (Cu) | Rest |

2. Bauteil nach Anspruch 1, **dadurch gekennzeichnet, dass** der Gewichtsanteil des Elements Chrom (Cr) in der Schutzschicht 3 % beträgt.

3. Bauteil nach Anspruch 1 oder 2, **dadurch gekennzeichnet, dass** die Schichtdicke der Schutzschicht 20 ö 50 µm beträgt.

4. Bauteil nach einem oder mehreren der Ansprüche 1 bis 3, **dadurch gekennzeichnet, dass** die Schutzschicht als PVD-Schicht (Physical Vapour Deposition-Schicht) ausgeführt ist, insbesondere als durch Kathodenzerstäubung erzeugte Schicht .

## Claims

1. Component made from an alloy with a base of titanium, nickel, cobalt or iron, having at least one load-transmitting contact surface which transmits mechanical loads varying in magnitude and direction at high temperatures, and having a layer on the contact surface to protect against friction wear, friction corrosion and/or friction fatigue, in particular blades made from a titanium alloy with a protective layer mounted in a positive-fit arrangement at the foot region for gas turbine drives, **characterised in that** the protective layer is made from an alloy of the following elements in the following respective proportions as a percentage by weight:
| | | |
|---|---|---|
| Aluminium | (Al) | 4 to 8 % |
| Chromium | (Cr) | 2 to 5 % |
| Iron | (Fe) | 0 to 3.5 % |
| Copper | (Cu) | remainder. |

2. Component as claimed in claim 1, **characterised in that** the proportion by weight of the chromium (Cr) element in the protective layer is 3 %.

3. Component as claimed in claim 1 or 2, **characterised in that** the coating thickness of the protective layer is 20 to 50 µm.

4. Component as claimed in one or more of claims 1 to 3, **characterised in that** the protective layer is provided as a PVD layer (Physical Vapour Deposition layer), in particular is a layer obtained by cathode sputtering.

## Revendications

1. Pièce se composant d'un alliage à base de titane, de nickel, de cobalt ou de fer, comprenant au moins une surface de contact transmettant des charges, laquelle surface de contact, à des températures élevées, transmet des charges mécaniques se modifiant en importance et en direction, et, sur la surface de contact, comprenant une couche de protection contre l'usure par frottement, contre la corrosion due au frottement et/ou contre la fatigue due au frottement, en particulier des pales pour des moteurs de turbines à gaz, maintenues assemblées par sûreté de forme et se composant d'un alliage en titane comprenant une couche de protection dans la zone de l'emplanture,
**caractérisée**
**en ce que** la couche de protection est formée par un alliage se composant d'éléments suivants constitués de parties indiquées à chaque fois par un pourcentage en poids :
| | | |
|---|---|---|
| aluminium | (Al) | 4 ö 8 % |
| chrome | (Cr) | 2 ö 5 % |
| fer | (Fe) | 0 ö 3,5 % |
| cuivre | (Cu) | reste |

2. Pièce selon la revendication 1, **caractérisée en ce que** la partie en poids de l'élément chrome (Cr) est égale à 3 % dans la couche de protection.

3. Pièce selon la revendication 1 ou 2, **caractérisée en ce que** l'épaisseur de la couche de protection est de 20 ö 50 µm.

4. Pièce selon l'une ou plusieurs des revendications 1 à 3, **caractérisée en ce que** la couche de protection est réalisée comme une couche PVD obtenue par dépôt en phase vapeur par procédé physique *(Physical Vapour Deposition)*, en particulier comme une couche produite par pulvérisation cathodique.
